# EUROPEAN PATENT APPLICATION

(11) **EP 2 693 271 A1**
(43) Date of publication of application: **05.02.2014**
(21) Application number: 12199125.1
(22) Date of filing: 21.12.2012
(51) Int. Cl.: G03F 7/20, B82Y 35/00, G01B 11/02, G01B 11/06

(54) **Apparatus and method for measuring the dimensions of 1-dimensional and 0-dimensional nanostructures in real-time during epitaxial growth**

(30) Priority: 02.08.2012 EP 12179065
(71) Applicant: LayTec AG, 10709 Berlin (DE)
(72) Inventor: Anttu, Nicklas, 221 00 Lund (SE); Heurlin, Magnus, 221 00 Lund (SE); Borgström, Magnus, 221 00 Lund (SE); Samuelson, Lars, 221 00 Lund (SE); Xu, Hongqi, 221 00 Lund (SE); Kaspari, Christian, 12247 Berlin (DE)
(74) Representative: Gulde Hengelhaupt Ziebig & Schneider

(57) **Abstract**

The present invention relates to an apparatus and a method for measuring the dimensions of 1-dimensional and 0-dimensional nanostructures on semiconductor substrates in real-time during epitaxial growth.

The method includes either assigning a pre-calculated 3D-model from a data base to the sample, wherein pre-calculation of the 3D-model includes calculation of the interference effects of light reflected from the front and back interfaces of the nano-structure and calculation of the interference effects due to superposition of neighbouring wave-fronts reflected from the nano-structure area and wave-fronts reflected from the substrate area between the nano-structures; or calculating a 3D-model of the sample using the measured optical reflectances of the plurality of different measuring positions of the sample, wherein calculation of the 3D-model includes calculation of the interference effects of light reflected from the front and back interfaces of the nano-structure and calculation of the interference effects due to superposition of neighbouring wave-fronts reflected from the nano-structure area and wave-fronts reflected from the substrate area between the nano-structures.

## Description

The present invention relates to an apparatus and a method for measuring the dimensions of 1-dimensional and 0-dimensional nanostructures in real-time during epitaxial growth.

### BACKGROUND OF THE INVENTION

Optical real-time monitoring and related real-time analysis of thin-film structures during epitaxial growth are state-of-the-art techniques. Epitaxy methods such as MOCVD (metal-organic vapour-phase epitaxy) and MBE (molecular beam epitaxy) are used both in industry and in academic research. Usually there are appropriate optical view-ports available in the MOCVD or MBE growth chambers and optical real-time monitoring of the epitaxial growth process can be performed by reflection, transmission or ellipsometry (more general: optical in-situ measurements). Even if the thin films grown have a total thickness of only a few nanometers (so called 'quantum wells' or 2D nano-structures), today's optical in-situ metrology tools are sufficiently sensitive to follow in real-time the formation of such 2D nano-structures. The related real-time analysis of in-situ measurements on growing 2D nano-structures is also straight-forward, because the mathematical equations describing the optical properties of thin-film stacks are valid also for extremely thin layers (total thicknesses of only a few nanometers). For real-time growth analysis these thin-film optical equations (e.g., for normal incidence reflection) are numerically calculated and by comparison between the measured and the calculated reflection the current status of film thickness and/or film composition can be determined.

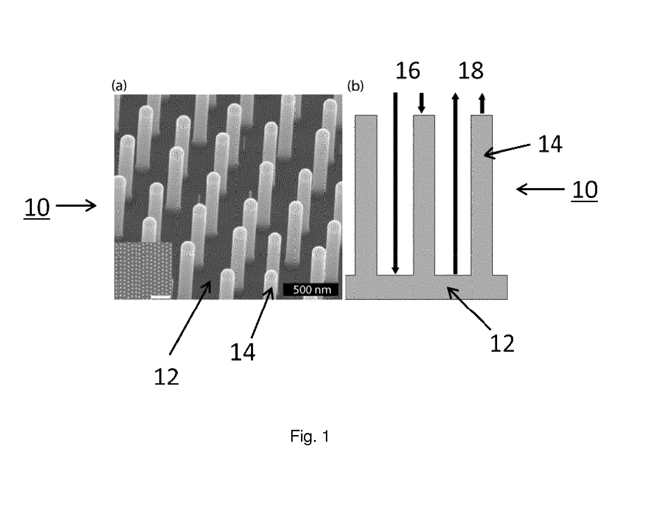

The conventional optical thin-film analysis described above works well for 2D nano-structures - but usually completely fails for 'nano-wires' (1D nano-structures, see Fig.1) and 0D nano-structures (so called 'quantum dots').

It is therefore an object of the present invention to provide an apparatus and a method for measuring the dimensions of 1-dimensional and 0-dimensional nanostructures in real-time during epitaxial growth, which overcomes the deficiencies of the prior art.

### SUMMARY OF THE INVENTION

According to an aspect of the present invention, a method for measuring the dimensions (of nanostructures) of a sample is disclosed.

According to a preferred embodiment of the invention, characteristic dimensions of the sample (nanostructures) can be measured in real-time.

According to another preferred embodiment of the invention, dimensions of the sample (nanostructures on a substrate) can be measured during epitaxial growth.

According to an aspect of the present invention, a method for determining the structural data of a sample which comprises nano-structures on a substrate is disclosed, the method comprising: irradiating optical radiation onto the sample, wherein an area of the sample onto which the optical radiation is irradiated ranges between 0.0004 mm² to 4mm², determining an optical reflectance signal of the sample from the reflected optical radiation, and determining structural data of the area of the sample onto which the optical radiation is irradiated, by either comparing the determined reflectance signal with reference signals of a data base and assigning three-dimensional structural data from the data base to the sample or by calculating structural data from the determined optical reflectance signal.

Even though it is possible to use monochromatic optical radiation, it is preferred that polychromatic optical radiation is used. Accordingly, a method for determining the structural data of a sample which comprises nano-structures on a substrate is disclosed, the method comprising: irradiating polychromatic optical radiation onto the sample, wherein an area of the sample onto which the polychromatic optical radiation is irradiated ranges between 0.0004 mm² to 4mm², determining an optical reflectance spectrum of the sample from the reflected polychromatic optical radiation, and determining structural data of the area of the sample onto which the polychromatic optical radiation is irradiated, by either comparing the determined reflectance spectrum with reference spectra of a data base and assigning structural data from the data base to the sample or by calculating structural data from the determined optical reflectance signal spectrum.

Preferably, the assignment of the structural data from the data base to the sample is made based on the comparison result.

Preferably, the data base contains a plurality of pairs of pre-defined three-dimensional structures and pre-calculated optical reflectance spectra.

In case that the characteristic dimensions of the sample (three-dimensional structural data, nanostructures) are determined by assigning such data from a data base to the sample, the characteristic dimensions of the sample can advantageously be determined (measured) in real-time.

The polychromatic optical radiation which is irradiated onto the sample preferably comprises substantially parallel propagating rays (radiation), more preferably consists of substantially parallel propagating rays, still more preferably consists of parallel propagating rays. Preferably, substantially parallel radiation is radiation having a divergence angle of less than 10°, more preferably less than 5°, more preferably less than 2° and still more preferably less than 0.5°.

Preferably, collimated polychromatic optical radiation is used. Preferably, the polychromatic optical radiation is irradiated perpendicularly onto the sample. Preferably a cross-section of the irradiated polychromatic optical radiation comprises a circular shape or rectangular shape.

Preferably, a ratio of the minimum energy density and the maximum energy density of the polychromatic optical radiation ranges between 0.1 and 1, more preferably between 0.3 and 1, more preferably between 0.5 and 1, more preferably between 0.7 and 1, more preferably between 0.9 and 1. Still more preferably, a ratio of the minimum energy density and the maximum energy density of the polychromatic optical radiation is 1, i.e. the energy density is uniform over the whole cross-section of the irradiated polychromatic optical radiation.

Preferably, the polychromatic optical radiation being irradiated onto the sample comprises a wavelength spectrum from the range between 200 nm and 2000 nm, preferably from the range between 400 nm and 900 nm. Preferably, the wavelength spectrum is continuous (with respect to intensity) in the mentioned ranges.

Preferably, a ratio of an intensity of a wavelength from said wavelength spectrum which has the lowest intensity and an intensity of a wavelength from said wavelength spectrum which has the highest intensity ranges between 0.1 and 1, more preferably between 0.3 and 1, more preferably between 0.5 and 1, more preferably between 0.7 and 1 and still more preferably between 0.9 and 1.

Preferably, an area of the sample onto which the polychromatic optical radiation is irradiated ranges between 0.0025 mm² to 1mm², preferably between 0.0025 mm² to 0.25mm² and more preferably between 0.005 mm² to 0.025mm².

Preferably, the data base contains a plurality of pre-defined three-dimensional structures, each pre-defined structure being assigned with a pre-calculated optical reflectance spectrum, wherein each pre-calculated optical reflectance spectrum is calculated by including interference effects due to superposition of neighbouring wave-fronts reflected from the nano-structure and wave-fronts reflected from the substrate between the nano-structures.

Preferably, the measured optical reflectance spectrum of the sample is compared with a plurality of pre-calculated optical reflectance spectra from the data base, and the structural data of the best-fitting pre-calculated optical reflectance spectrum is assigned to the sample.

Preferably, the step of calculating the three-dimensional structural data of the sample includes a scattering matrix method.

Preferably, at least one from the group selected from pre-known parameters of the sample, optical properties of the material of the nano-structures, optical properties of the material of the substrate, optical properties of the material of an ambient medium and the irradiated polychromatic optical radiation are used as input parameters for pre-calculating the structural data of the sample.

Preferably, the sample is a structure of nano-wires arranged on a semiconductor substrate. Preferably, the sample comprises a (substantially) regular pattern of nano-wires. Preferably, a ratio of a pitch L between adjacent nano-wires and a median wavelength λ_{M} of the irradiated radiation ranges between 0.01 and 100, more preferably between 0.1 and 10, more preferably between 0.3 and 3, more preferably between 0.5 and 2, more preferably between 0.7 and 1.4, more preferably between 0.8 and 1.25 and still more preferably between 0.9 and 1.1. Preferably, a ratio of a (maximum) diameter D of the cross-section of the nano-wires and a median wavelength λ_{M} of the irradiated radiation ranges between 0.01 and 100, more preferably between 0.1 and 10, more preferably between 0.3 and 3, more preferably between 0.5 and 2, more preferably between 0.7 and 1.4, more preferably between 0.8 and 1.25 and still more preferably between 0.9 and 1.1. The pitch of the nano-wires means a distance in which the regularly arranged nano-wires are repeated. A median wavelength λ_{M} is the wavelength which divides the total irradiated energy into two parts (over the time of irradiation) of wavelengths lower than median wavelength λ_{M} and wavelengths greater than median wavelength λ_{M}, the two parts having the same total amount of energy.

The time period in which the polychromatic optical radiation is irradiated onto the sample (for each irradiation spot = an area of the sample) preferably ranges between 0.1s and 10s, more preferably between 0.01s and 1s and still more preferably between 0.0001 and 0.01 s.

Preferably, the polychromatic optical radiation is irradiated onto a plurality of different areas of the sample, an optical reflectance spectrum is determined for each of the plurality of areas and structural data each of the plurality of areas of the sample are determined from the respective reflectance spectra. More preferably, the polychromatic optical radiation is continuously scanned over the sample, and structural data of the sample are continuously determined for the areas over which the polychromatic optical radiation is continuously scanned, and from the obtained structural data of the plurality of measuring spots, the overall structural data of the sample are determined. That is, that the spot size is limited and due to scanning the measuring spot, the structural data of a plurality of partial areas of the sample can be determined. From these structural data of the plurality of partial areas, the structural data for (the whole or) a larger are of the sample can be determined. At least, it is possible to determine the structural data for the whole area of the sample for which structural data shall be obtained. In this case, scanning over sample can be made such that neighbouring scanning areas are either adjacent or partially overlapping. The spatial resolution of the structural data becomes more precise if the overlap of neighbouring scanning areas becomes larger. That is, the overlap of neighbouring scanning areas is preferably larger than 1%, more preferably larger than 5%, more preferably larger than 10%, more preferably larger than 20% and still more preferably larger than 40%.

Preferably, an area covered by the plurality of areas covers at least 10% of the total area of the sample. More preferably, an area covered by the plurality of areas covers at least 30%, more preferably at least 50%, more preferably at least 70% and still more preferably at least 90% of the total area of the sample.

Preferably, pre-known parameters of the sample structure and the optical properties of the sample material, the substrate material and of the ambient medium are used as input parameters.

Preferably a calculation of structural data and/or a calculation of the reference spectra (for pre-defined structural data) is performed by using a scattering matrix method as e.g. known from Anttu, N. & Xu, H. Q., "Scattering matrix method for optical excitation of surface plasmons in metal films with periodic arrays of sub-wavelength holes", Physical Review B 83, 165431 (2011).

Preferably 3D-modelling of the light-sample interaction is performed by using versions of the Fourier Modal Method or, alternatively, formulations of the Rigorous Coupled Wave Approximation (RCWA).

For real-time analysis of the sample structure (e.g. an epitaxial nano-structure growth) it is preferred that the calculated optical response (reflectances) of the sample (e.g. nano-structure on a substrate) is stored before the measurement of the reflectances in a data base for all structural and compositional parameters relevant for the sample (e.g. a specific nano-structure growth process). During the measurement of the reflectances (e.g. during the growth process), from this pre-calculated multi-dimensional data-base of optical response data carefully optimized fast data-mining algorithms will find the best-fitting optical spectra (in case of spectroscopic in-situ monitoring) or the best fitting single-/multi-wavelength optical transients (in case of single-/multi-wavelength optical in-situ monitoring) for real-time determination of the characteristic sample parameters (e.g. nano-structure parameters).

For samples with structure dimensions of approximately the same order of magnitude as the transversal coherence length of the probing light, a semi-classical approach as described in Strittmatter, A. & , Reißmann, L. & Trepk, T. & Pohl, U.W. & Bimberg, D. & Zettler, J.-T., "Optimization of GaN MOVPE growth on patterned Si substrates using spectroscopic in situ reflectance", Journal of Crystal Growth 272, 76 (2004) can be taken. Here, spectra of virtual planar samples corresponding to the bottom and the top of the nano-structure are taken from the database. Their complex reflection coefficients are subsequently added, assuming a layer of air (or other suitable material) in between whose thickness can be varied to fit the aspect ratio of the nanowire structure. For a certain class of nano-dimensional structures and for an optimised polarisation direction of the incident light, this approach is faster than selecting the best-fitting spectrum from the pre-calculated database. Preferably, samples with structure dimensions of approximately the same order of magnitude as the transversal coherence length of the probing light are understood as samples where a ratio of a transversal coherence length of the probing light and a pitch L between adjacent nano-structures ranges between 0.1 and 10, more preferably between 0.3 and 3, more preferably between 0.5 and 2, more preferably between 0.7 and 1.4 and still more preferably between 0.9 and 1.1.

Preferably, the sample is a nano-wire (NW) structure on the surface of a semiconductor wafer. Preferably, the sample comprises a nano-wire (NW) structure having a regular pattern.

Preferably, the lateral dimension D of the sample, the central wavelength λ of the light used for measuring the optical reflectance and/or the pitch L of the regular pattern of the sample range between 100 and 2000nm, more preferably between 200 and 1500nm and still more preferably between 400 and 1000nm.

According to an aspect of the present invention, a method for controlling fabrication process parameters for the sample during epitaxial growth is disclosed, wherein structural data of at least a part of the sample are determined according to the method of the present invention, and fabrication process parameters of the sample are controlled according to the determined structural data. Such fabrication process parameters may be the pressure within a chamber in which the sample is grown, the temperature of the sample and the like.

According to an aspect of the present invention, an apparatus for determining structural data of a sample, comprising: means for irradiating polychromatic optical radiation onto the sample, wherein an area of the sample onto which the polychromatic optical radiation is irradiated ranges between 0.0004 mm² to 4mm², means for determining an optical reflectance spectrum of the sample from the reflected polychromatic optical radiation, and means for determining structural data of the area of the sample onto which the polychromatic optical radiation is irradiated, by either assigning three-dimensional structural data from a data base to the sample or by calculating three-dimensional structural data from the determined optical reflectance spectrum.

Preferably, the apparatus further comprises means for repeatedly scanning the polychromatic optical radiation over the sample.

According to an aspect of the present invention, an apparatus for controlling fabrication process parameters for the sample during epitaxial growth is disclosed, comprising an apparatus for determining structural data of the sample according to the method of the present invention, and further comprising means adapted to control fabrication process parameters for the sample according to the determined structural data of the sample.

According to an aspect of the present invention, a method is disclosed comprising: arranging the nano-structures on a substrate, both together forming the sample and measuring the optical reflectance of a plurality of different measuring positions of the sample (which is arranged on a substrate) with a spatial resolution ranging between 0.02mmx0.02mm and 2mmx2mm. More preferably, the spatial resolution ranges between 0.05mmx0.05mm and 0.5mmx0.5mm. Preferably, the optical reflectance of the sample is measured by scanning a focused white-light beam or a single-wavelength focused laser-beam over the sample. Preferably, the measuring positions are arranged uniformly over the sample; however, the invention is not restricted hereto.

Preferably, the optical reflectance is measured either in an appropriate spectral range (preferably between 200nm and 2000nm) for spectroscopic analysis of the sample's optical response or with a sufficiently large time-resolution in case of single wavelength or multiple-wavelength growth monitoring. This is useful for detecting sufficiently clear and structured interference patterns of the sample structure in the optical in-situ measurement.

The method further comprises calculating a 3D-model from the measured optical reflectances of the plurality of different measuring positions of the sample, wherein 3D-modelling is performed by incorporating both, the interference effects of light reflected from the front and back interfaces of the sample structure and the interference effects due to superposition of neighbouring wave-fronts reflected from the sample top area and wave-fronts reflected from the substrate area between the samples.

Preferably, pre-known parameters of the sample structure and the optical properties of the sample material, the substrate material and of the ambient medium are used as input parameters.

Preferably 3D-modelling of the light-sample interaction is performed by using a scattering matrix method as e.g. known from Anttu, N. & Xu, H. Q., "Scattering matrix method for optical excitation of surface plasmons in metal films with periodic arrays of sub-wavelength holes", Physical Review B 83, 165431 (2011).

Preferably 3D-modelling of the light-sample interaction is performed by using versions of the Fourier Modal Method or, alternatively, formulations of the Rigorous Coupled Wave Approximation (RCWA).

For real-time analysis of the sample structure (e.g. during epitaxial nano-structure growth) it is preferred that the calculated optical response (reflectances) of the sample (e.g. nano-structure on a substrate) is stored before the measurement of the reflectances in a data base for all structural and compositional parameters relevant for the sample (e.g. a specific nano-structure growth process). During the measurement of the reflectances (e.g. during the growth process), from this pre-calculated multi-dimensional data-base of optical response data carefully optimized fast data-mining algorithms will find the best-fitting optical spectra (in case of spectroscopic in-situ monitoring) or the best fitting single-/multi-wavelength optical transients (in case of single-/multi-wavelength optical in-situ monitoring) for real-time determination of the characteristic sample parameters (e.g. nano-structure parameters).

For samples with structure dimensions of approximately the same order of magnitude as the transversal coherence length of the probing light, a semi-classical approach as described in Strittmatter, A. & , Reißmann, L. & Trepk, T. & Pohl, U.W. & Bimberg, D. & Zettler, J.-T., "Optimization of GaN MOVPE growth on patterned Si substrates using spectroscopic in situ reflectance", Journal of Crystal Growth 272, 76 (2004) can be taken. Here, spectra of virtual planar samples corresponding to the bottom and the top of the nano-structure are taken from the database. Their complex reflection coefficients are subsequently added, assuming a layer of air (or other suitable material) in between whose thickness can be varied to fit the aspect ratio of the nanowire structure. For a certain class of nano-dimensional structures and for an optimised polarisation direction of the incident light, this approach is faster than selecting the best-fitting spectrum from the pre-calculated database.

Preferably, the sample is a nano-wire (NW) structure on the surface of a semiconductor wafer. Preferably, the sample comprises a nano-wire (NW) structure having a regular pattern.

In case of single-/multi-wavelength optical in-situ monitoring, the light used for measuring the optical reflectance of a plurality of different measuring positions of the sample, preferably is monochromatic.

In case of spectroscopic optical in-situ monitoring, the white light used for measuring the optical reflectance of a plurality of different measuring positions of the sample, preferably is in the spectroscopic range between 200nm<λ<2000nm (λ is the central wavelength of the spectroscopic range).

Preferably, the pitch L of the regular pattern of the sample and the central wavelength λ of the light used for measuring the optical reflectance satisfy the condition 0.1 < L/λ <10, more preferably 0.25 < L/λ <4 and still more preferably 0.5 < L/λ <2. Preferably, the (maximum) lateral dimension D of the regular pattern of the sample and the wavelength λ of the light used for measuring the optical reflectance satisfy the condition 0.1 < D/λ <10, more preferably 0.25 < D/λ <4 and still more preferably 0.5 < D/λ <2.

Preferably, the lateral dimension D of the sample, the central wavelength λ of the light used for measuring the optical reflectance and/or the pitch L of the regular pattern of the sample range between 100 and 2000nm, more preferably between 200 and 1500nm and still more preferably between 400 and 1000nm.

According to another aspect of the present invention, an apparatus for measuring the dimensions of nano-structures on a substrate (of a sample) is disclosed.

The apparatus comprises means for measuring the optical reflectance of a plurality of different measuring positions on a sample with a spatial resolution ranging between 0.02mm x 0.02mm and 2mm x 2mm.

The apparatus further comprises means for calculating a 3D-model from the measured optical reflectances of the plurality of different measuring positions of the sample, wherein 3D-modelling is performed incorporating both, the interference effects of light reflected from the front and back interfaces of the nano-structure and the interference effects due to superposition of neighbouring wave-fronts reflected from the nano-structure area and wave-fronts reflected from the substrate area between the nano-structures.

Preferably, the apparatus further comprises a data base for storing structural and compositional parameters relevant for the sample.

Preferably, the apparatus further comprises means for comparing measured reflectances with pre-calculated reflectances stored in the data base. Preferably, the apparatus further comprises means for assigning the measured reflectances to best-fitting pre-calculated reflectances stored in the data base. The structure used for pre-calculating the assigned best-fitting pre-calculated reflectances is then used as the structure of the sample.

For samples with structure dimensions of approximately the same order of magnitude as the transversal coherence length of the probing light, a semi-classical approach as described in Strittmatter, A. & , Reißmann, L. & Trepk, T. & Pohl, U.W. & Bimberg, D. & Zettler, J.-T., "Optimization of GaN MOVPE growth on patterned Si substrates using spectroscopic in situ reflectance", Journal of Crystal Growth 272, 76 (2004) can be taken. Here, spectra of virtual planar samples corresponding to the bottom and the top of the nano-structure are taken from the database. Their complex reflection coefficients are subsequently added, assuming a layer of air (or other suitable material) in between whose thickness can be varied to fit the aspect ratio of the nanowire structure. For a certain class of nano-dimensional structures and for an optimised polarisation direction of the incident light, this approach is faster than selecting the best-fitting spectrum from the pre-calculated database.

### BRIEF DESCRIPTION OF THE DRAWINGS

In the following the invention will be described in further detail. The examples given are adapted to describe the invention, but not to limit the invention in any case.
- Fig. 1: shows a Scanning Electron Microscopy (SEM) image (a) and schematic cross-sectional image (b) of a nano-wire (NW) array,
- Fig. 2: shows a schematic top view to a nano-wire (NW) structure for introducing the key structural parameters: diameter D of the NWs and period length L of the NW array structure. The NW top area is sketched in gray in front of the substrate area between the NWs,
- Fig. 3: shows measured and 3D-optically modelled reflectance spectra of NW arrays (measured spectroscopic reflectance R of three periodic InP NW arrays). The best fitting modelled spectra refer to NWs of diameter d=121 nm and length L=533 nm for sample A; d=124 nm and L=855 nm for sample B; and d=124 nm and L=1445 nm for sample C, and
- Fig. 4: shows an apparatus for controlling fabrication process parameters of the sample during epitaxial growth.

### DETAILED DESCRIPTION OF THE DRAWINGS

Fig. 1 shows a Scanning Electron Microscopy (SEM) image (a) and schematic cross-sectional image (b) of a NW array. The SEM image (30° tilt from top-view) is showing NWs of high local uniformity as grown by selective MOCVD growth on a nano-masked semiconductor substrate. The inset shows a top view SEM image of the mask pattern prior to growth with auxiliary gold (Au) particles catalysing the subsequent NW growth. The distance between the NWs, their diameter and heights are 400 nm, 100nm and 1000nm, respectively. The scale bar in the inset is 2 µm long. (b) Sketch of light reflected at the air/NW top interface and the NW/substrate bottom interface.

The present invention discloses a method and an apparatus for performing optical in-situ measurements and related real-time analysis of critical structural parameters of 'nano-wires' and 'quantum dots' during their formation in epitaxial processes.

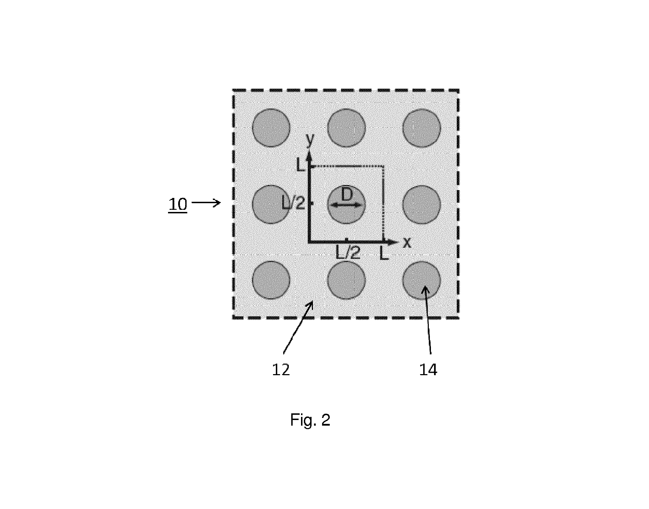

More specifically, the present invention is of special importance for the optical analysis of such 1D and 0D nanostructures having critical dimensions (diameter D and nano-wire length L, see Fig.2 for reference) in the range between 100nm and 2000nm, i.e., in the same range as the wavelength λ of the visible and/or near-infra-red light that typically is used for optical in-situ measurements.

Fig. 2 shows a schematic top view to a nano-wire (NW) structure for introducing the key structural parameters: diameter D of the NWs and nano-wire length L of the NW array structure. The NW top area is sketched in gray in front of the substrate area between the NWs.

Only in the lower-limit case, where L<<λ and D<<λ, or in the upper limit case, where L>>λ and D>>λ, the conventional optical thin-film analysis can be applied successfully. In the lower-limit case so called effective medium models can be used for transforming the structure into a quasi-homogeneous film with an effective refractive index and an effective extinction coefficient. Certain scaling parameters in the specific effective medium model can be fitted to the nano-structure.

In the upper-limit case a straight-forward weighted superposition of the conventionally calculated reflectance response of the NW top area and of the substrate area between the NWs can be applied.

In the case of L∼λ and/or D∼λ, which is of significant practical importance, the conventional thin-film optical modelling methods completely fail and the following new method has to be applied:
1. The optical reflectance has to be measured with an appropriate spatial resolution of the measurement spot (typical range between 0.02mm x 0.02mm and 2mm x 2mm) that on the one hand side is large enough to integrate over a sufficiently large number of nano-structures and on the other hand is small enough to avoid suppression of the interference patterns due to local variations of the characteristic NW parameters L and D within the detection spot. This is of importance when there are spatial non-uniformities in the specific MBE or MOCVD growth process.
2. The optical reflectance has to be measured either in an appropriate spectral range (typically between 200nm and 2000nm) for spectroscopic analysis of the NWs optical response or with a sufficiently large time-resolution in case of single wavelength or multiple-wavelength growth monitoring. This is necessary for detecting sufficiently clear and structured interference patterns of the NW structure in the optical in-situ measurement.
3. Since the measured interference patterns of the NW structures cannot be modelled by conventional (1-dimensional) thin-film optical methods, the following modelling technique has to be applied: The interaction between the plane waves of the measurement light with the nano-structure has to be calculated by numerically solving Maxwell's equations through full three-dimensional optical modelling. The nano-scaled parameters D and L of the NW structure and the optical properties of the NW material, the substrate material and of the ambient medium have to be used as input parameters. A scattering matrix method as published in Anttu, N. & Xu, H. Q. Scattering matrix method for optical excitation of surface plasmons in metal films with periodic arrays of sub-wavelength holes. Physical Review B 83, 165431 (2011) or well known versions of the Fourier Modal Method or, alternatively, some formulations of the Rigorous Coupled Wave Approximation (RCWA) can be applied for performing the full 3D-modelling of the interaction between light and nano-structure. The key difference to the conventional thin-film optical methods is that not just the interference effects of light reflected from the front and back interfaces of the NW structure contribute but also the interference effects due to superposition of neighbouring wave-fronts reflected from the NW top area and wave-fronts reflected from the substrate area between the NWs.
4. Because the direct 3D numerical solution of Maxwell's equations for the calculation of the reflectance (or transmittance) response of NW or QD arrays is taking, even when very fast computers are used, typically several hours of calculation time, for real-time analysis of epitaxial nano-structure growth a further step is necessary: the calculated optical response of the nano-structure has to be saved in a sufficiently large data base for all structural and compositional parameters relevant for the specific nano-structure growth process. Later, during the growth process, from this pre-calculated multi-dimensional data-base of optical response data fast data-mining algorithms have to find the best-fitting optical spectra (in case of spectroscopic in-situ monitoring) or the best fitting single-/multi-wavelength optical transients (in case of single-/multi-wavelength optical in-situ monitoring) for real-time determination of the characteristic nano-structure parameters. For samples with structure dimensions of approximately the same order of magnitude as the transversal coherence length of the probing light, a semi-classical approach as described in Strittmatter, A. & , Reißmann, L. & Trepk, T. & Pohl, U.W. & Bimberg, D. & Zettler, J.-T., "Optimization of GaN MOVPE growth on patterned Si substrates using spectroscopic in situ reflectance", Journal of Crystal Growth 272, 76 (2004) can be taken. Here, spectra of virtual 2D- planar samples corresponding to the bottom and the top of the nano-structure are taken from the database. Their complex reflection coefficients are subsequently added, assuming a layer of air (or other suitable material) in between whose thickness can be varied to fit the aspect ratio of the nanowire structure. For a certain class of nanowire samples-dimensional structures and for an optimised polarisation direction of the incident light, this approach is faster than selecting the best-fitting spectrum from the pre-calculated database.

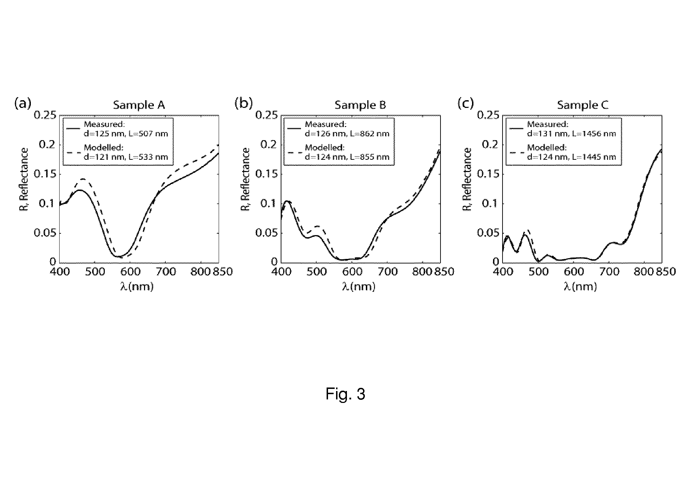

In Fig. 3 an example result is given. Spectroscopic reflectance measurements (solid lines) with 0.1 mm x 0.1 mm spatial resolution have been performed on InP nano-wires grown by MOCVD on masked InP substrates. The spectra shown as broken lines have been calculated according to the method described above. Fig. 3 shows measured and 3D-optically modelled reflectance spectra of three periodic InP NW arrays. The best fitting modelled spectra refer to NWs of diameter d=121 nm and length L=533 nm for sample A; d=124 nm and L=855 nm for sample B; and d=124 nm and L=1445 nm for sample C.

Such NW arrays are currently intensively investigated as potential nano-scaled building blocks for enhancing the performance of semiconductor devices in the areas of photonics and optoelectronics. Possible applications are for example solar cells, light emitting diodes, lasers and photo-detectors. In all these applications both the NW diameter and length play important roles in the optical response of the devices. Using the method described here, one is able to determine in real-time and simultaneously both the NW diameter and length with accuracy far better than the diffraction limit and well within 10% of the values obtained from SEM measurements.

The method and apparatus is applicable for an even wider range of nano-structures and other periodically arranged 3-dimentional objects of nano-meter dimension.

The angle of incidence between the incoming light and the substrate below the nano-structure in not restricted to 0° (normal incidence), i.e., the method works well also for non-normal (oblique) incidence.

The different areas of the nano-structure contributing to the reflection of plane waves are not restricted to only two (as described above) - more complex nano-structures having more than two contributing nano-sized sub-areas can be analysed with the same method, requiring only slightly more complex models for the numerical solution of Maxwell's equation.

The different areas of the nano-structures contributing to the reflection of plane waves can even be tilted with respect to each other. Such nano-structures (e.g., having tilted facets with a certain tilt-angle) can be analysed, e.g., by multi-angle-of-incidence reflectance and basically the same numerical calculation method, requiring more complex models for the numerical solution of Maxwell's equation, respectively.

The method can be expanded from in-situ reflectance and transmittance analysis also to in-situ ellipsometry: the phase-shifting effects of the 1D- and 0D-nanostructures are included in the scattering matrix method.

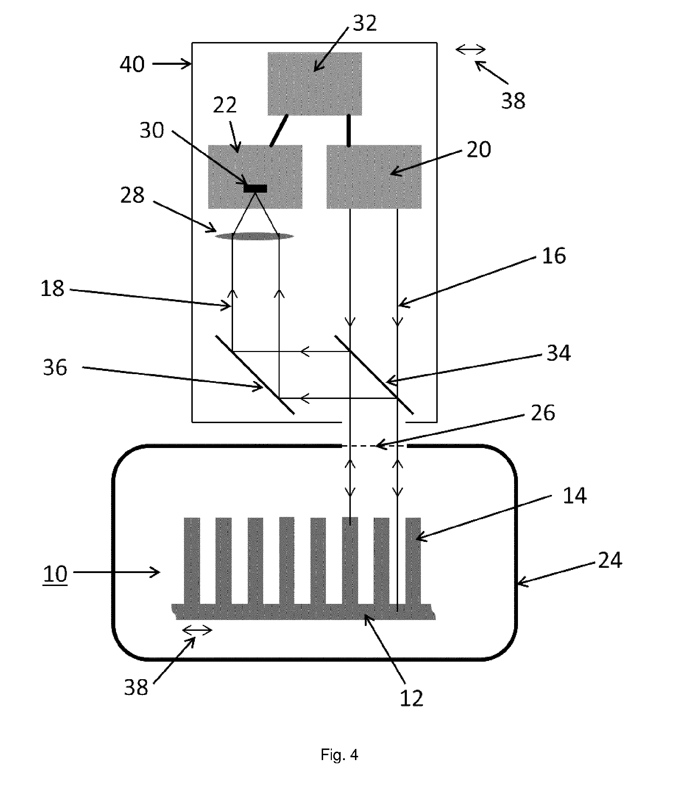

Fig.4 shows a schematical view of an apparatus for controlling fabrication process parameters of the sample during epitaxial growth according to an embodiment of the present invention.

The sample 10 comprising the substrate 12 and the plurality of regularly arranged nano-wires 14 is arranged within a process chamber 24 which is adapted to perform epitaxial growth of the sample 10. Preferably, the nano-wires 14 are arranged in a regular matrix but the invention is not limited thereto.

The process chamber 24 comprises means to control the temperature of the sample 10 by direct or indirect heating, the chamber pressure - through a combination of pressure controllers and process pumps - , the concentration and mixture of precursor material, e.g. by using mass flux controllers, and the rotation speed of the sample 10 for homogenisation of the growth.

The InP NW samples 14 shown in Fig. 3 were grown using the VLS method with Au catalyst particles defined by nanoimprint lithography (NIL) on a (111)B InP substrate 12. The NIL pattern has a period of 400 nm with aligned columns of Au particles where each column is slightly offset. A high quality pattern was obtained on 2" wafers using an Obducat AB developed process with an intermediate polymer stamp (IPS®) and soft press® technology. Smaller samples were subsequently cleaved from the 2" wafer and used in the growth process. All nanowire samples 10 were grown in a horizontal metal-organic vapour phase epitaxy reactor using tri-methyl-indium (TMIn) and phosphine (PH₃) as precursor gases. HCl gas was used in order to minimize diameter changes otherwise induced by parasitic radial growth. Samples A-C (Fig. 3) were grown by using different nanowire growth times of 5.5, 11 and 22 min, respectively. The Au particles were then removed ex-situ by a wet chemical process, before a re-growth step of 30 min was performed to define the final nanowire dimensions. All VLS nanowire growth was done at 395 °C at a total reactor pressure of 100 mbar using molar fractions χTMIn = 8.3x10⁻⁶, χPH₃ = 190x10⁻³ and χHCl = 1.0x10⁻⁵, while the re-growth step was done at 550°C at a total reactor pressure of 400 mbar using χTMIn = 18.0x10⁻⁶ and χPH₃ = 36.0x10⁻³.

The process chamber 24 comprises one window 26. A light source 20 produces white light which has a continuous spectrum within the visible wavelength range (380 to 760 nm). The light source 20 is preferably a heat radiator such as a tungsten lamp. The incident polychromatic optical radiation 16 is perpendicularly irradiated through the window 26 onto the sample 10 which is located within the process chamber 24. Before reaching the window 26, the incident polychromatic optical radiation 16 passes a partial mirror 34. After the incident polychromatic optical radiation 16 reaches the substrate 12 and the nano-wires 14, the optical radiation is reflected in dependence of the structural data of the substrate 12 and the plurality of nano-wires 14 which has been illuminated by the light source 20.

The diameter of the incident polychromatic optical radiation 16 (or equivalently the area of the sample which is irradiated) is chosen such that it is on the one hand side large enough to integrate over a sufficiently large number of nano-structures 14 and that it is on the other hand small enough to avoid suppression of the interference patterns due to local variations of the characteristic nano-wire parameters L and D within the detection spot (Fig. 2). This is of importance when there are spatial non-uniformities in the specific MBE or MOCVD growth process. MBE or MOCVD growth are preferred processes used for epitaxial growth of the sample 10.

Due to the chosen dimensions of the detection spot (measuring spot or area of the sample which is irradiated in relation to the spatial dimensions of the nano structures), not just interference effects of light reflected from the front and back interfaces of the nano-wire structure but also the interference effects due to superposition of neighbouring wave-fronts reflected from the nano-wire top area and wave-fronts reflected from the substrate area between the nano-wires contribute to the reflection spectrum.

Then, the reflected optical radiation 18 passes through the window 26 of the process chamber 24, is diverted by the mirrors 34 and 36, and is focussed by the lens 28 onto the detector 30, which is part of the detection means 22 which detects a spectrum of the reflected optical radiation 18. In the embodiment of the present invention, the light source 20, the detection means 22, the control means 32, the mirrors 34 and 36 and the lens 28 are integrated in a mutual housing of the scanning unit 40. However, the invention is not limited thereto, and it is alternatively possible to arrange the light source 20, the detection means 22, the control means 32, the mirrors 34 and 36 and the lens 28 separately from each other. The scanning unit 40 and/or the sample 10 itself may be moved along a direction 38 which is perpendicular to the incident optical radiation 16. In case of scanning the scanning unit 40 laterally over the sample 10, the window 26 has to be adapted such that incident optical radiation 16 and reflected optical radiation 18 can pass into and from the chamber 24 along the whole scanning path.

Then, the spectrum, which is obtained from the detector 30, is input into the control means 32 which then determines structural 3D data (i.e. the dimensions of the wires 14 as well as their pitch L) of the area of the sample 10 onto which the optical radiation 16 is irradiated by comparing the obtained reflectance spectrum with a plurality of pre-calculated reference spectra of a data base which is integrated in the control means 32. In the present embodiment, the measured optical reflectance spectrum of the sample 10 is compared with a plurality of pre-calculated optical reflectance spectra as e.g. shown in Fig. 3a to 3c and the pre-defined structural data of the best-fitting pre-calculated optical reflectance spectrum is assigned to the sample 10. That is, in case of an obtained spectrum as shown in fig. 3a, a comparison with the plurality of pre-calculated reference spectra of the data base would result in a best-fitting spectrum which has been pre-calculated based in nano wires with a diameter d=121 nm and length (pitch) L=533 nm, and accordingly these structural 3D data are now assigned to the spot of the sample 10 which is irradiated by the incident polychromatic optical radiation 16. The determination of the structural 3D data of the sample 10 is performed in real time, i.e. the irradiation is repeatedly performed and the structural 3D data of the sample 10 are repeatedly determined. Preferably, the repetition rate of the determination of the structural data is higher than 0.01 Hz, more preferably higher than 0.1 Hz, more preferably higher than 1 Hz and still more preferably higher than 10 Hz. In addition, the measuring spot, i.e. the area onto which the polychromatic optical radiation 16 is irradiated and which is limited in size, may be repeatedly scanned over the whole sample 10 and from the obtained spectra, a plurality of structural 3D data of (different, but potentially overlapping areas of) the sample 10 are determined which may then be assembled (or composed) such to obtain a 3D model of the whole sample. The 3D modelling of the whole sample is preferably also performed in real time. Preferably, the repetition rate of the scanning of the sample (one cycle) is higher than 0.01 Hz, more preferably higher than 0.1 Hz, more preferably higher than 1 Hz and still more preferably higher than 10 Hz.

### List of reference signs

- 10: sample
- 12: substrate
- 14: nano-wire
- 16: incident optical radiation
- 18: reflected optical radiation
- 20: light source
- 22: means for detecting an optical reflectance spectrum
- 24: process chamber
- 26: window of process chamber
- 28: means for focusing the reflected optical radiation
- 30: detector
- 32: control means
- 34: partial mirror
- 36: mirror
- 38: moving direction of scanning means
- 40: scanning unit
- L: pitch of nano-wires
- D: diameter of nano-wires

## Claims

1. A method for determining the structural data of a sample (10) which comprises nano-structures (12) on a substrate (14), the method comprising:
- irradiating optical radiation onto the sample (10), wherein an area of the sample (10) onto which the optical radiation is irradiated ranges between 0.0004 mm² to 4mm²,
- determining an optical reflectance signal of the sample (10) from the reflected optical radiation, and
- determining structural data of the area of the sample (10) onto which the optical radiation is irradiated, by either comparing the determined reflectance signal with reference signals of a data base and assigning three-dimensional structural data from the data base to the sample (10) or by calculating structural data from the determined optical reflectance signal.

2. The method of claim 1, wherein polychromatic optical radiation is irradiated onto the sample (10), and an optical reflectance spectrum of the sample (10) is determined from the reflected polychromatic optical radiation, and the structural data of the area of the sample (10) are determined by either comparing the determined reflectance spectrum with reference spectra of a data base and assigning structural data from the data base to the sample (10) or by calculating structural data from the determined optical reflectance signal spectrum.

3. The method of claim 1, wherein collimated polychromatic optical radiation is used which is irradiated perpendicularly onto the sample (10) and/or wherein a cross-section of the irradiated polychromatic optical radiation comprises a circular shape or rectangular shape.

4. The method according to any one of the preceding claims, wherein the polychromatic optical radiation being irradiated onto the sample (10) comprises a wavelength spectrum from the range between 400 nm and 900 nm; and/or wherein an area of the sample (10) onto which the polychromatic optical radiation is irradiated ranges between 0.0025 mm² to 0.25mm².

5. The method according to any one of the preceding claims, wherein the data base contains a plurality of pre-defined three-dimensional structures, each pre-defined structure being assigned with a pre-calculated optical reflectance spectrum, wherein each pre-calculated optical reflectance spectrum is calculated by including interference effects due to superposition of neighbouring wave-fronts reflected from the nano-structure (12) and wave-fronts reflected from the substrate (14) between the nano-structures (12).

6. The method according to any one of the preceding claims, wherein the measured optical reflectance spectrum of the sample (10) is compared with a plurality of pre-calculated optical reflectance spectra from the data base, and the structural data of the best-fitting pre-calculated optical reflectance spectrum is assigned to the sample (10).

7. The method according to any one of claims 5 and 6, wherein calculating the three-dimensional structural data of the sample (10) and/or pre-calculating reference spectra includes a scattering matrix method.

8. The method according to any one of the preceding claims, wherein the sample (10) is a structure of nano-wires (12) arranged on a semiconductor substrate (14); and/or wherein the sample (10) comprises a regular pattern of nano-wires (12).

9. The method according to any one of the preceding claims, wherein polychromatic optical radiation is irradiated onto a plurality of different areas of the sample (10), an optical reflectance spectrum is determined for each of the plurality of areas and structural data each of the plurality of areas of the sample (10) are determined from the respective reflectance spectra.

10. The method according to claim 9, wherein the plurality of different areas of the sample (10) are arranged either adjacently or partially overlapping to each other.

11. The method according to claim 10, wherein the plurality of areas cover at least 50% of the total area of the sample (10).

12. The method according to any one of the preceding claims, further comprising the step of controlling fabrication process parameters for the sample (10) according to the determined structural data.

13. An apparatus for determining structural data of a sample (10), comprising:
- means for irradiating polychromatic optical radiation onto the sample (10),
wherein an area of the sample (10) onto which the polychromatic optical radiation is irradiated ranges between 0.0004 mm² to 4mm²,
- means for determining an optical reflectance spectrum of the sample (10) from the reflected polychromatic optical radiation, and
- means for determining structural data of the area of the sample (10) onto which the polychromatic optical radiation is irradiated, by either assigning three-dimensional structural data from a data base to the sample (10) or by calculating three-dimensional structural data from the determined optical reflectance spectrum.

14. The apparatus of claim 13, further comprising means for repeatedly scanning the polychromatic optical radiation over the sample (10).

15. The apparatus of claim 13, further comprising means adapted to control fabrication process parameters for the sample (10) according to the determined structural data of the sample (10)
